# EUROPÄISCHE PATENTANMELDUNG

(11) **EP 4 372 236 A1**
(43) Veröffentlichungstag der Anmeldung: **22.05.2024**
(21) Anmeldenummer: 22208182.0
(22) Anmeldetag: 17.11.2022
(51) Int. Cl.: F15B 21/08, G05B 23/02, H02P 29/024

(54) **BEWEGUNGSERKENNUNG ELEKTRONISCHER ANTRIEBE**

(71) Anmelder: Murrelektronik GmbH, 71570 Oppenweiler (DE)
(72) Erfinder: RÖDIGER, Jonny, 04442 Zwenkau (DE); SCHOCH, Fabian, 71522 Backnang (DE); WOLFF, Ingo, 74613 Öhringen (DE)
(74) Vertreter: Karzel, Philipp

(57) **Zusammenfassung**

Die Erfindung betrifft ein Busmodul mit einer Ansteuereinheit (50) zur Ansteuerung von elektromagnetischen Aktoren (2) einer Maschinensteuerung (10) über einen Bus (5), insbesondere zur Ansteuerung von Aktoren (2) mit einem elektromagnetisch bewegten Anker (21) wie Schaltventile (20), Schütze (30) oder dgl., wobei der Aktor (2) über eine elektrische Leitung (3) und die Ansteuereinheit (50) mit einer Energiequelle (9) verbunden ist, und mit einem in der elektrischen Leitung (3) angeordneten Stromsensor (4), der ausgebildet ist, den in der elektrischen Leitung (3) fließenden momentanen Betriebsstroms (I) eines Aktors (2) zu erfassen. Um den Verschleißzustand eines Aktors (2) zu erkennen ist vorgesehen, dass das Busmodul (1) eine Recheneinheit (40) umfasst, wobei der Stromsensor (4) mit der Recheneinheit (40) verbunden ist, und die Recheneinheit (40) ausgebildet ist, das Ausgangssignal (41) des Stromsensors (4) zu verarbeiten, wobei die Ansteuereinheit (50), die Recheneinheit (40) und der Stromsensor (4) in einem gemeinsamen Modulgehäuse (8) angeordnet sind.

## Beschreibung

Die Erfindung betrifft die Überwachung von elektromagnetischen Aktoren einer Maschinensteuerung. Eine Maschinensteuerung ist im Sinne der Erfindung eine SPS (speicherprogrammierbare Steuerung) oder eine Industrie PC Steuerung. Zu einer Maschinensteuerung können auch Edge Gateways zur Verarbeitung von Daten aus dem Shopfloor und eine Anbindung an Cloud Systeme gehören. Insbesondere werden über Cloud Systeme Maschinen gesteuert bzw. generierte und erfasste Daten weiterverarbeitet. Aus Edge Gateways und/oder Cloud Systemen können auch Wartungsaufträge generiert werden, die den Servicemitarbeitern zur Verfügung gestellt werden oder in andere Systeme wie ERP Systeme (Enterprise-Resource-Planning) eingespielt werden

Als Aktoren sind innerhalb eines verteilten Systems einer Produktionsanlage, einer Transportanlage oder dgl. Anlagen zum Beispiel Schaltventile, Schütze, Stellglieder und dgl. vorgesehen, die einen elektromagnetisch bewegten Anker aufweisen. Der elektromagnetische Aktor ist über eine elektrische Leitung mit einer Energiequelle verbunden und wird von einer in einem Busmodul vorgesehenen Ansteuereinheit angesteuert. Das Busmodul mit der Ansteuereinheit kann mit der übergeordneten Maschinensteuerung über eine Datenverbindung, insbesondere einen geeigneten Bus (Datenbus, Steuerbus oder dgl. Bus) verbunden sein, über den auch entsprechende Steuerbefehle an die Ansteuereinheit übermittelt werden können.

Zur Erfassung des in der Zuleitung zu einem Aktor fließenden Stroms in der elektrischen Leitung ist ein Stromsensor (Shunt Widerstand) anzuordnen. Der Betriebsstrom, die Betriebsspannung oder auch die elektrische Aufnahmeleistung des Aktors lassen eine Aussage über den Zustand des Aktors zu. Hierzu ist eine entsprechende Auswerteeinheit notwendig, die meist einen Mikroprozessor mit erheblicher Rechenleistung benötigt.

Der Erfindung liegt die Aufgabe zugrunde, ein Busmodul zur Auswertung von über einen Stromsensor erfasste Daten eines Aktors anzugeben, der einfach aufgebaut ist und eine nur geringe Rechenleistung zur Auswertung der Daten des Stromsensors erfordert.

Die Aufgabe wird nach den Merkmalen des Anspruchs 1 gelöst. Das Busmodul umfasst eine Recheneinheit, mit der der Stromsensor unmittelbar verbunden ist. Die Recheneinheit ist ausgebildet, das Ausgangssignal des Stromsensors unmittelbar zu verarbeiten. Die Ansteuereinheit, die Recheneinheit und auch der Stromsensor sind in einem gemeinsamen Modulgehäuse des Busmoduls vorgesehen. Dadurch ist ein einfacher Aufbau zur Verwendung in Maschinensteuerungen erzielt. Innerhalb des Modulgehäuses sind alle notwendigen elektrischen Verbindungen zwischen dem Stromsensor und der Recheneinheit ausgebildet, sodass eine äußere Verkabelung des Stromsensors entfällt.

Die Recheneinheit ist insbesondere ausgebildet, die Steigung di/dt des Ausgangssignals des Stromsensors über der Zeit zu ermitteln. Ein Abweichen des zeitlichen Verhaltens des Ausgangssignals und/oder ein Abweichen der Kurvenform von einem erwarteten Verhalten kann auf eine Störung am Aktor hinweisen. Insbesondere kann ein zu steiler Anstieg des Betriebsstroms ebenso wie ein zu flacher Anstieg des Betriebsstroms ein Merkmal für einen Verschleiß oder eine Störung im Aktor sein.

Bei einem Aktor mit einem elektromagnetisch bewegten Anker ist die Recheneinheit ausgebildet, die Zeitpunkte der Nulldurchgänge der Steigung di/dt durch eine Nullachse festzustellen und mit einem Zeitstempel zu versehen. Insbesondere ist die Recheneinheit ausgebildet, die mit einem Zeitstempel erfassten Zeitpunkte der Nulldurchgänge abzuspeichern. Mit nur wenigen Daten können aus den Zeitpunkten der Nulldurchgänge wesentliche Kennwerten des elektromagnetischen Aktors wie die Startzeit, die Flugzeit und/oder die Beruhigungszeit ermittelt werden.

Es kann vorteilhaft sein, die Recheneinheit derart auszubilden, dass auch die Absolutwerte des fließenden Betriebsstroms und/oder Absolutwerte der Steigung di/dt des Stromanstiegs oder Abfalls und/oder die Spannung am Aktor erfasst, mit einem Zeitstempel versehen und abgespeichert werden.

In einer Ausführungsform der Erfindung ist die Recheneinheit derart ausgebildet, dass die erfassten Zeitpunkte der Nulldurchgänge mit den zugeordneten Zeitstempeln und/oder die erfassten Absolutwerte des Betriebsstroms über den Bus der zentralen Maschinensteuerung übermittelt werden.

Die Recheneinheit und/oder die Maschinensteuerung ist derart ausgebildet, aus den Zeitstempeln der Nulldurchgänge bevorzugte Kennwerte des Aktors zu berechnen. So kann aus der Differenz der Zeitstempel aufeinanderfolgender Nulldurchgänge z.B. die Flugzeit des Ankers des elektromagnetischen Aktors bestimmt werden. Alternativ oder ergänzend können aus der Differenz der Zeitstempel der Nulldurchgänge der Steigung di/dt auch weitere Kennwerte des elektromagnetischen Aktors wie beispielsweise die Startzeit des Ankers und/oder die Beruhigungszeit des Ankers bestimmt werden. Der bei jeder Betätigung des Aktors erfasste Kennwert des Ankers gibt Auskunft über den Zustand des Aktors, seinen Verschleiß oder in ihm auftretende Störungen. Dieses kann über die Recheneinheit am Busmodul ebenso angezeigt werden wie an einer zentralen Maschinensteuerung oder an einer Überwachungseinrichtung, so zum Beispiel einer Schalttafel, einer HMI (Human Machine Interface) und/oder einer zugeordneten Cloud und/oder einer ERP (Enterprise-Resource-Planning) oder dgl. und vorteilhaft zur Wartungsplanung genutzt werden.

Die Maschinensteuerung und/oder die Recheneinheit ist ausgebildet, einen ermittelten Kennwert des Ankers der elektromagnetischen Aktoren gleichen Typs und gleicher Bauart miteinander zu vergleichen. Bei signifikanter Abweichung eines aktuell überprüften Kennwertes eines Ankers eines elektromagnetischen Aktors mit ermittelten Kennwerten gleichen Typs des Ankers eines anderen elektromagnetischen Aktors gleichen Typs und gleicher Bauart kann ein Warnsignal ausgegeben werden. Unter Kennwerten werden die Startzeit des Ankers, und/oder die Flugzeit des Ankers und/oder die Beruhigungszeit des Ankers verstanden. Diese Kennwerte werden aus der Differenz der Zeitstempel der Nulldurchgänge bestimmt. Kennwerte des Aktors sind alternativ oder ergänzend auch die Absolutwerte des fließenden Betriebsstroms und/oder Absolutwerte der Steigung di/dt des Stromanstiegs oder Abfalls und/oder die Spannung am Aktor.

Die Maschinensteuerung und oder die Recheneinheit kann auch derart ausgebildet sein, die abgespeicherten Kennwerte wie z.B. die Flugzeiten des Ankers eines einzelnen elektromagnetischen Aktors miteinander zu vergleichen. Bei signifikanter Abweichung eines aktuell ermittelten Kennwerts wie einer aktuellen Flugzeit des Ankers mit anderen ermittelten Kennwerten wie die Flugzeiten des gleichen Ankers des elektromagnetischen Aktors wird ein Warnsignal ausgegeben. Auch in dieser Ausführungsform werden unter Kennwerten die vorstehend genannten Kennwerte wie Startzeit des Ankers, Flugzeit des Ankers, Beruhigungszeit des Ankers, Absolutwerte des fließenden Betriebsstroms und/oder Absolutwerte der Steigung di/dt des Stromanstiegs oder Abfalls und/oder die Spannung am Aktor eines Aktors verstanden.

Die Maschinensteuerung und/oder die Recheneinheit kann auch derart ausgebildet sein, um einen ermittelten Kennwert wie z.B. die Flugzeit eines Ankers eines elektromagnetischen Aktors mit einem vorgegebenen Kennwert einer Flugzeit zu vergleichen. Bei signifikanter Abweichung eines aktuell ermittelten Kennwertes wie z.B. der Flugzeit des Ankers des elektromagnetischen Aktors mit einem vorgegebenen Kennwert wie z.B. einer vorgegebenen Flugzeit des Ankers wird ein Warnsignal ausgegeben.

Nach der Erfindung kann über ermittelte Kennwerte wie die Bewegung des Ankers eines elektromagnetischen Aktors während dem laufenden Betrieb eines Gesamtsystems kontinuierlich eine Überprüfung der Aktoren gewährleistet werden, sodass frühzeitig ein zu erwartender Ausfall eines Aktors erkannt und angezeigt werden kann. Der Benutzer hat so die Möglichkeit, in einer Betriebspause oder in einem Wartungsintervall kritische Aktoren auszutauschen, sodass ein Ausfall des Gesamtsystems während dem Betrieb vermieden werden kann.

Weitere Merkmale der Erfindung ergeben sich aus den Ansprüchen, der nachfolgenden Beschreibung sowie der Zeichnung, in der schematisch eine Darstellung eines Systems mit zumindest einem Aktor mit einem elektromagnetisch bewegten Anker und mehrere Aktoren unterschiedlicher Bauart gezeigt sind. Die in den Ansprüchen, der Beschreibung genannten und in der Zeichnung dargestellten Merkmale sind untereinander frei kombinierbar.

Die Zeichnungen zeigen wie folgt:
- Fig. 1: eine schematische Darstellung einer pneumatischen Steuerung in einem Gesamtsystem wie einer Transportanlage, einer Produktionsanlage, einer Sortieranlage o. dgl. Anlage,
- Fig. 2: ein Strom-/Spannungsdiagramm des Betriebsstroms eines elektromagnetischen Aktors mit einem bewegten Anker,
- Fig. 3: ein Diagramm der Steigung di/dt des Betriebsstroms mit Nulldurchgängen,
- Fig. 4: eine schematische Darstellung eines elektromagnetischen Ventils,
- Fig. 5: eine schematische Darstellung eines elektromagnetischen Schalters,
- Fig. 6: eine schematische Darstellung eines Schützes.

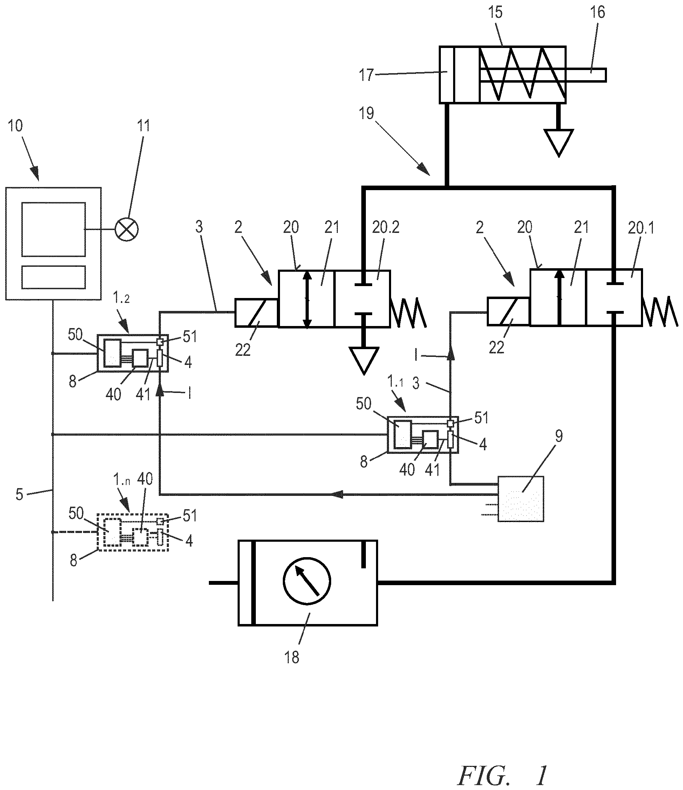

In Figur 1 ist schematisch ein Ausschnitt aus einem System wie einer Produktionsanlage, einer Transportanlage, einer Sortieranlage oder dergleichen Anlage gezeigt. Der Ausschnitt zeigt den elektrischen Schaltplan zur Ansteuerung von Schaltventilen 20, die als Schaltventile 20.1 und 20.2 eines pneumatischen Stellgliedes 15 mit einer Stellstange 16 dargestellt sind. Der dargestellte Fluidkreis kann sowohl flüssiges wie gasförmiges Fluid enthalten. Dies umfasst auch einen Hydraulikkreis.

Die Druckkammer 17 des pneumatischen Stellgliedes 15 wird über einen Druckminderer 18 über ein erstes elektromagnetisches Schaltventil 20.1 gespeist. Ein zweites an die Druckkammer 17 angeschlossenes elektromagnetisches Schaltventil 20.2 dient der Entlastung der Druckkammer 17 mit der Folge, dass die Stellstange 16 des Stellgliedes 15 zurückgezogen wird. Der Druckminderer 18, die Schaltventile 20 bzw. 20.1 und 20.2 und das Stellglied 15 bilden einen pneumatischen Stellkreis 19.

Die Schaltventile 20 bilden elektromagnetische Aktoren 2 mit einem Anker 21, der elektromagnetisch zu bewegen ist. In Fig. 1 liegen die Anker 21 der Schaltventile 20.1 und 20.2 in ihrer Ruhelage. Die Spulen 22 der elektromagnetischen Antriebe sind stromlos.

Jedes Schaltventil 20.1 und 20.2 ist über ein Busmodul 1.1 und 1.2 von einer Maschinensteuerung 10 ansteuerbar. Im gezeigten Ausführungsbeispiel umfasst ein Busmodul 1.1, 1.2 bzw. weitere Busmodule 1.n eine Ansteuereinheit 50, eine Recheneinheit 40 sowie einen Stromsensor 4. Zweckmäßig umfasst das Busmodul 1.1, 1.2 bzw. 1.n auch eine Schalteinheit 51, die den elektrischen Antriebskreis der Spule 22 des elektromagnetischen Antriebs schaltet.

Bevorzugt ist die Ansteuereinheit 50, die Recheneinheit 40 und der Stromsensor 4 in einem gemeinsamen Modulgehäuse 8 des Busmoduls 1.1, 1.2 bzw. 1.n angeordnet. Zweckmäßig ist auch die Schalteinheit 51 zur Inbetriebnahme der Spule 22 des elektromagnetischen Antriebs im Modulgehäuse 8 angeordnet. Es kann vorteilhaft sein, das Busmodul mit mehreren Kanälen auszubilden.

Die Spule 22 eines Aktors 2 ist über eine elektrische Leitung 3 mit einer Energiequelle 9 verbunden. Die elektrische Leitung 3 ist durch das Busmodul 1.1 bzw. 1.2 durchgeschleift, wobei innerhalb des Modulgehäuses 8 die von der Ansteuereinheit 50 betätigte Schalteinheit 51 die elektrische Leitung 3 schaltet. Innerhalb des Modulgehäuses 8 ist in der elektrischen Leitung 3 der Stromsensor 4 zur Erfassung des Betriebsstroms I vorgesehen, dessen Ausgangssignal über eine Signalleitung 41 der Recheneinheit 40 zugeführt ist.

Die mit dem Stromsensor 4 verbundene Recheneinheit 40 ist ausgebildet, das Ausgangssignal des Stromsensors 4 zu verarbeiten. So kann die Recheneinheit 40 die Steigung di/dt des Ausgangssignals des Stromsensors 4 über der Zeit ermitteln.

Aus dem Ausgangssignal des Stromsensors 4 können vorteilhaft Kennwerte des Aktors 2 abgeleitet werden, wie auch die Absolutwerte des fließenden Betriebsstroms I und/oder Absolutwerte der Steigung di/dt des Stromanstiegs oder Abfalls und/oder die Spannung am Aktor 2 bestimmt werden. Ein Abweichen des zeitlichen Verhaltens des Ausgangssignals und/oder ein Abweichen der Kurvenform von einem erwarteten Verhalten kann auf eine Störung am Aktor hinweisen. Es kann ein zu steiler Anstieg des Betriebsstroms I oder ein zu langsamer Anstieg des Betriebsstroms I ein Hinweis auf einen defekten oder in naher Zukunft ausfallenden Aktor 2 sein. Zweckmäßig wird bei Erkennen eines fehlerhaften Kennwertes ein Warnsignal ausgegeben. Zweckmäßig werden die erfassten Kennwerte wie die Absolutwerte des fließenden Betriebsstroms I, die Absolutwerte der Steigung di/dt und/oder die erfassten Spannungswerte mit einem Zeitstempel versehen und abgespeichert.

In besonderer Ausgestaltung der Erfindung wird die erste Ableitung der Kurve des Betriebsstroms I ermittelt, nämlich die Steigung di/dt. Die Kurve der Steigung di/dt weist Nulldurchgänge durch eine Nullachse auf, die mit je einem Zeitstempel versehen werden. Die Recheneinheit ermittelt den Zeitpunkt Ts des Starts der Inbetriebnahme des Aktors und/oder die Zeitpunkte T_{F}, T_{A}, T_{E} der Nulldurchgänge der Steigung di/dt der Kurve des Betriebsstroms I durch eine Nullachse N. Den Nulldurchgängen T_{F}, T_{A}, T_{E} und zweckmäßig dem Startzeitpunkt Ts der Inbetriebnahme (Einschalten) des Aktors 2 wird ein Zeitstempel zugeordnet. Vorteilhaft ist die Recheneinheit derart ausgebildet, dass die erfassten Zeitpunkte T_{F}, T_{A}, T_{E} und zweckmäßig der Startzeitpunkt T_{S} abgespeichert werden. Hierzu kann in der Recheneinheit 40 selbst und/oder in der übergeordneten Maschinensteuerung 10 ein entsprechender Speicher vorgesehen sein.

Die Recheneinheit 40 kann ausgebildet sein, die Zeitstempel der Nulldurchgänge, also die erfassten Zeitpunkte T_{F}, T_{A}, T_{E} und zweckmäßig den Startzeitpunkt Ts der Inbetriebnahme (Einschalten) des Aktors 2 und/oder die erfassten Absolutwerte des Betriebsstroms I an die zentrale Maschinensteuerung 10 zu übermitteln. Dies erfolgt vorteilhaft über einen Bus 5, über den auch die einzelnen Busmodule 1.1, 1.2 bis 1.n angesteuert werden. Der Bus 5 kann ein Feldbus oder auch eine I/O-Link Verbindung sein.

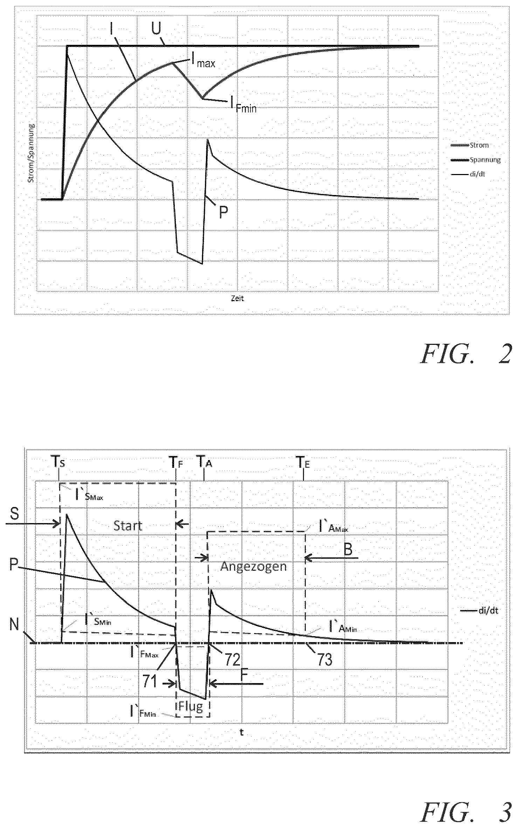

In Fig. 2 ist ein Strom-/Spannungsdiagramm gezeigt, in welchem der Betriebsstrom I dargestellt ist. Der Betriebsstrom I steigt bis zu einem Maximalstrom Iₘₐₓ an, bis sich der Anker 21 des elektromagnetischen Aktors 2 bewegt. Die körperliche Bewegung des Ankers 21 aus seiner Ruhestellung in die angezogene Stellung im Zeitpunkt T_{A} bezeichnet man als Flug, die dabei verstreichende Zeit als Flugzeit F. Während der Flugzeit F des Ankers 21 fällt der Betriebsstrom I bis auf einen Wert I_{Fmin} ab. Am Ende der Flugzeit F des Ankers 21 (Zeitpunkt T_{A}) stellt sich der Betriebsstrom I auf einen Haltestrom ein. Die Spannung U ist bei intaktem Aktor über der Zeit gleich bzw. im Wesentlichen unverändert.

Der Stromsensor 4 meldet über die Signalleitung 41 die Kurve des Betriebsstroms I an die Recheneinheit 40. Die Recheneinheit 40 ermittelt aus der Kurve des Betriebsstroms I deren Steigung di/dt und stellt die Nulldurchgänge der Kurve P der Steigung di/dt durch eine Nullachse N fest. Ausgehend vom Start der Bestromung des Aktors 2 zum Zeitpunkt T_{S} gibt der erste Nulldurchgang 71 der Kurve P der Steigung di/dt den Zeitpunkt T_{F} der beginnenden Bewegung des Ankers 21 wieder. Dieser Startpunkt wird mit einem ersten Zeitstempel versehen. Der zweite Nulldurchgang 72 der Kurve P der Steigung di/dt zum Zeitpunkt T_{A} gibt den angezogenen Zustand des Ankers 21 wieder. Dieser Nulldurchgang wird mit einem weiteren Zeitstempel versehen. Im Zeitpunkt T_{A} ist der Anker 21 an seinem Endanschlag angekommen. Der weitere Nulldurchgang 73 ist eine asymptotische Annäherung der Kurve P der Steigung di/dt an die Nullachse N. Zum Zeitpunkt T_{E} liegt der Anker 21 in vollständiger Ruhe an seinem Endanschlag. Auch dieser Nulldurchgang wird mit einem Zeitstempel versehen.

Die Zeitstempel T_{S}, T_{F}, T_{A}, und T_{E} können zueinander in Bezug gesetzt werden, sodass sich aus diesen Zeitstempeln signifikante Kennwerte wie die Zeitdauer des Starts des Aktors 2 bis zur Bewegung des Ankers 21, die Flugzeit des Ankers 21 und die Zeit bis zur Ruhe des Ankers 21 an einem Endanschlag bestimmen lassen.

Wie insbesondere in Fig. 3 dargestellt, ergibt sich aus der Differenz des Zeitstempels T_{F} mit dem Zeitstempel Ts die Startzeit S des Ankers (T_{F} - Ts = Z). Aus der Differenz des Zeitstempels T_{A} zum Zeitstempel T_{F} ergibt sich die Flugzeit F (T_{A} - T_{F} = F) des Ankers 21. Aus der Differenz des Zeitstempels T_{E} zum Zeitstempel T_{A} ergibt sich die Beruhigungszeit B (T_{E} - T_{A} = F) des Ankers 21 bis zur vollständigen Bewegungsruhe.

Die Startzeit S, die Flugzeit F, und die Beruhigungszeit B sind charakteristische Kennwerte eines elektromagnetischen Aktors 2 mit einem bewegten Anker 21.

Die Recheneinheit 40 und/oder die Maschinensteuerung 10 ist ausgebildet, aus den Zeitstempeln T_{S}, T_{F}, T_{A}, und T_{E} zumindest die Flugzeit F des Ankers 21 eines elektromagnetischen Aktors 2 zu bestimmen. Die Auswertung der Zeitstempel benötigt nur eine geringe Rechenkapazität. Die Übermittlung der Zeitstempel an eine Maschinensteuerung umfasst nur wenige Daten. Zweckmäßig werden auch die Kennwerte zur Startzeit S und zur Beruhigungszeit B bestimmt.

Vorteilhaft wird ein Kennwert wie insbesondere die ermittelte Flugzeit F eines Aktors 2 mit einem Kennwert wie die ermittelten Flugzeit F des Ankers 21 eines im gleichen System verwendeten elektromagnetischen Aktors 2 gleichen Typs und gleicher Bauart verglichen. Bei einer signifikanten Abweichung eines aktuell ermittelten Kennwertes wie die Flugzeit F eines Ankers mit dem Kennwert einer ermittelten Flugzeit des Ankers eines anderen elektromagnetischen Aktors gleichen Typs und gleicher Bauart im System wird ein Warnsignal auszugeben. Hierzu kann zum Beispiel die Maschinensteuerung 10 eine optische Warnanzeige 11 aufweisen. Eine derartige Warnanzeige 11 kann auch am Modulgehäuse 8 vorgesehen sein.

In gleicher Weise kann die Recheneinheit 40 und/oder die Maschinensteuerung 10 aus den Zeitstempeln T_{S}, T_{F}, T_{A}, und T_{E} die Kennwerte der Startzeit S und/oder der Beruhigungszeit B des Ankers 21 eines elektromagnetischen Aktors mit den Kennwerten einer Startzeit S und/oder einer Beruhigungszeit B des Ankers 21 eines anderen im System verwendeten elektromagnetischen Aktors 2 vergleichen. Bei einer signifikanten Abweichung kann über die Maschinensteuerung 10 und/oder das Busmodul 1.1, 1.2 bzw. 1.n eine Warnanzeige generiert werden, vorteilhaft eine optische Warnanzeige 11 aktiviert werden.

Unter einer signifikanten Abweichung wird ein um 20 % bis 30 % größerer oder kleinerer Wert verstanden. Über- oder unterschreitet die Flugzeit F, die Startzeit S und/oder die Beruhigungszeit B den Vergleichswert eines anderen im gleichen Systemverwendeten Aktors 2 um 20 % bis 30 %, wird die Warnanzeige 11 aktiviert.

Vorteilhaft ist vorgesehen, die Flugzeit F, die Startzeit S und/oder die Beruhigungszeit B eines elektromagnetischen Aktors 2 abzuspeichern, insbesondere in der Recheneinheit 40 und/oder der Maschinensteuerung 10 abzuspeichern.

Eine abgespeicherte Flugzeit F, eine abgespeicherte Startzeit S und/oder eine abgespeicherte Beruhigungszeit B des einzelnen elektromagnetischen Aktors 2 kann auch mit einer aktuell ermittelten Flugzeit F, einer aktuell ermittelten Startzeit S und/oder einer aktuell ermittelten Beruhigungszeit B desgleichen bzw. desselben elektromagnetischen Aktors 2 verglichen werden. Bei einer signifikanten Abweichung wird - wie vorstehend beschrieben - ein Warnsignal ausgegeben. Auch in diesem Zusammenhang wird unter einer signifikanten Abweichung ein um 20 % bis 30 % größerer oder kleinerer Wert verstanden. Die Grenzen einer zulässigen Abweichung können auch durch das System selbst bestimmt werden. So kann vorteilhaft die Recheneinheit 40 zweckmäßig über eine Statistische Messung des elektromagnetischen Aktors 2 im Neuzustand über z.B. den Kennwerten aus z.B. 1000 Schaltungen und ein Vielfaches der ermittelten Standardabweichung (z.B. 7 sigma) die zulässigen Grenzen ermitteln und festlegen.

In weiterer Ausgestaltung der Erfindung kann die Maschinensteuerung 10 und/oder die Recheneinheit 40 so ausgebildet sein, dass die ermittelte Flugzeit F, die ermittelte Startzeit S und/oder die ermittelte Beruhigungszeit B eines Aktors 2 mit einem vorgegebenen Sicherheitswert für die Flugzeit, die Startzeit und/oder die Beruhigungszeit verglichen werden. Bei signifikanter Abweichung einer aktuell ermittelten Flugzeit F, Startzeit S und/oder Beruhigungszeit B des Ankers 21 des elektromagnetischen Aktors 2 wird ein Warnsignal ausgegeben. Auch in diesem Zusammenhang wird unter einer signifikanten Abweichung ein um 20 % bis 30 % größerer oder kleinerer Wert verstanden.

Es kann auch vorteilhaft sein, die Recheneinheit 40 derart auszubilden, dass sie eine statistische Auswertung der über eine vorgegebene Anzahl an Schaltvorgängen erfassten Kennwerte durchführt und das Ergebnis der statistischen Auswertung der Maschinensteuerung 10 übermittelt. Insbesondere werden Minimal- und Maximalwerte sowie Mittelwerte und Trends der ermittelten Kennwerte an die Maschinensteuerung 10 übermittelt.

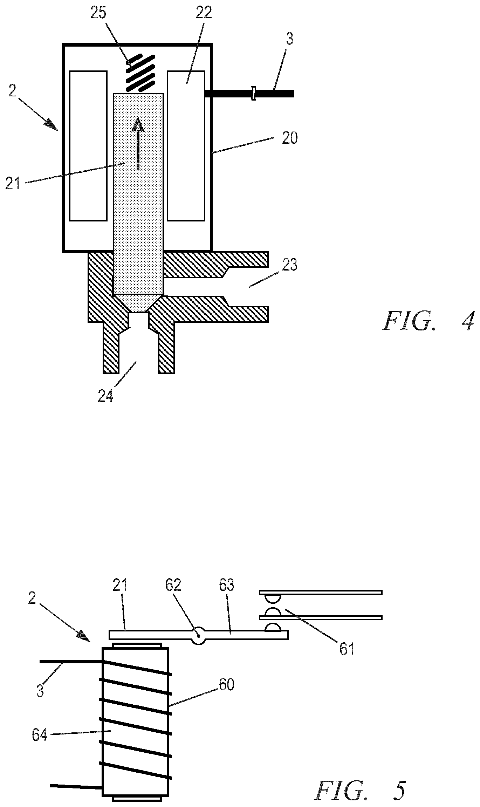

In den Fig. 4 bis Fig. 6 sind Beispiele weiterer Aktoren 2 schematisch dargestellt.

In Fig. 4 ist ein Schaltventil 20 gezeigt, dessen Antrieb eine zu bestromende Spule 22 aufweist. Ist die Spule 22 bestromt, wird der Anker 21 in Pfeilrichtung bewegt, sodass eine hydraulische Verbindung zwischen einem Zulauf 23 und einem Ablauf 24 geöffnet wird. Wird der über die elektrische Leitung 3 zugeführte Strom abgeschaltet, wird der Anker 21 unter der Wirkung der Rückstellfeder 25 wieder in die in Fig. 4 gezeigte Schließstellung verschoben.

In Fig. 5 ist der Aktor 2 als elektrisches Schaltrelais 60 mit einem Kontaktpaar 61 ausgebildet. Ein um eine Drehachse 62 gelagerter Kontakthebel 63 bildet den Anker 21 des elektromagnetischen Aktors 2. Wird die Spule 64 des elektromagnetischen Antriebs bestromt, wird der Anker 21 angezogen und verschwenkt den Kontakthebel 63 um die Drehachse 62. Dadurch wird das Kontaktpaar 61 geschlossen. Wird der Strom abgeschaltet, fällt das Schaltrelais 60 ab und das Kontaktpaar 61 öffnet.

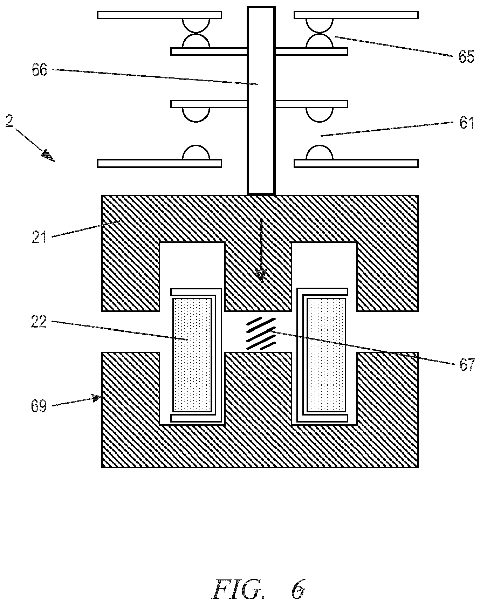

In Fig. 6 ist schematisch ein Schütz 69 dargestellt. Das Schütz ist ein elektromagnetisch betätigter Schalter für große elektrische Leistungen und ähnelt im Aufbau einem Relais. Das Schütz 69 hat ein erstes Kontaktpaar 61 das als Schließer ausgebildet ist. Über den Anker 21 und den Kontaktträger 66 wird ein zweites Kontaktpaar 65 gesteuert, welches im Ausführungsbeispiel als Öffner ausgebildet ist. In der in Fig. 6 dargestellten Schaltstellung ist die Spule 22 des Aktors 2 stromlos. Unter der Wirkung der Rückstellfeder 67 ist das erste Kontaktpaar 61 geöffnet und das zweite Kontaktpaar 65 geschlossen. Wird die Spule 22 bestromt, wird der Anker 21 in Pfeilrichtung angezogen mit der Folge, dass das erste Kontaktpaar 61 schließt und das zweite Kontaktpaar 65 öffnet.

## Patentansprüche

1. Busmodul mit einer Ansteuereinheit (50) zur Ansteuerung von
elektromagnetischen Aktoren (2) einer Maschinensteuerung (10) über einen Bus (5),
insbesondere zur Ansteuerung von Aktoren (2) mit einem elektromagnetisch bewegten Anker (21) wie Schaltventile (20), Schütze (69) oder dgl.,
wobei der Aktor (2) über eine elektrische Leitung (3) und die Ansteuereinheit (50) mit einer Energiequelle (9) verbunden ist,
und mit einem in der elektrischen Leitung (3) angeordneten Stromsensor (4), der ausgebildet ist, den in der elektrischen Leitung (3) fließenden momentanen Betriebsstroms (I) eines Aktors (2) zu erfassen,
**dadurch gekennzeichnet,**
**dass** das Busmodul (1) eine Recheneinheit (40) umfasst,
**dass** der Stromsensor (4) mit der Recheneinheit (40) verbunden ist, und dass die Recheneinheit (40) ausgebildet ist, das Ausgangssignal (41) des Stromsensors (4) zu verarbeiten, wobei die Ansteuereinheit (50), die Recheneinheit (40) und der Stromsensor (4) in einem gemeinsamen Modulgehäuse (8) angeordnet sind.

2. Busmodul nach Anspruch 1,
**dadurch gekennzeichnet, dass** die Recheneinheit (40) ausgebildet ist, die Steigung di/dt des Ausgangssignal (41) über der Zeit zu ermitteln und die Zeitpunkte (T_{S}, T_{F}, T_{A}, T_{E}) der Nulldurchgänge der Steigung di/dt durch eine Nullachse festzustellen und mit einem Zeitstempel zu versehen.

3. Busmodul nach einem der Ansprüche 1 oder 2,
**dadurch gekennzeichnet, dass** die Recheneinheit (40) ausgebildet ist, die erfassten Zeitpunkte (T_{S}, T_{F}, T_{A}, T_{E}) der Nulldurchgänge mit den zugeordneten Zeitstempeln abzuspeichern.

4. Busmodul nach einem der Ansprüche bis 1 bis 3,
**dadurch gekennzeichnet, dass** die Recheneinheit (40) ausgebildet ist, die Absolutwerte von Kennwerten wie des fließenden Betriebsstroms (I), der Betriebsspannung (U) oder dgl. mit einem Zeitstempel zu versehen und abzuspeichern.

5. Busmodul nach einem der Ansprüche 1 bis 4,
**dadurch gekennzeichnet, dass** die Recheneinheit (40) ausgebildet ist, die erfassten Zeitpunkte (T_{S}, T_{F}, T_{A}, T_{E}) der Nulldurchgänge mit den zugeordneten Zeitstempeln und/oder die erfassten Absolutwerte des Betriebsstroms (I) über den Bus (5) an die zentrale Maschinensteuerung (10) zu übermitteln.

6. Busmodul nach einem der Ansprüche 1 bis 5,
**dadurch gekennzeichnet, dass** die Recheneinheit (40) oder die Maschinensteuerung (1) ausgebildet ist, aus den Zeitpunkten (Ts, T_{F}, T_{A}, T_{E}) der Zeitstempel der Nulldurchgänge Kennwerte des elektromagnetischen Aktors (2) wie beispielsweise die Startzeit (S) des Ankers (21), die Flugzeit (T) des Ankers (21) und/oder die Beruhigungszeit (B) des Ankers (21) des elektromagnetischen Aktors (2) zu bestimmen.

7. Busmodul nach Anspruch 6,
**dadurch gekennzeichnet, dass** die Maschinensteuerung (1) oder die Recheneinheit (40) ausgebildet ist, die ermittelten Kennwerte des elektromagnetischen Aktors (2) wie beispielsweise die Startzeiten (S) des Ankers (21), die Flugzeiten (T) des Ankers (21) und/oder die Beruhigungszeiten (B) des Ankers (21) der elektromagnetischen Aktoren (2) gleichen Typs und gleicher Bauart miteinander zu vergleichen und bei signifikanter Abweichung eines aktuell ermittelten Kennwertes eines Ankers (21) eines elektromagnetischen Aktors (2) mit einem ermittelten Kennwert gleichen Typs des Ankers (21) eines anderen elektromagnetischen Aktors (2) gleichen Typs und gleicher Bauart ein Warnsignal auszugeben.

8. Busmodul nach Anspruch 6,
**dadurch gekennzeichnet, dass** die Maschinensteuerung (1) oder die Recheneinheit (40) ausgebildet ist, die abgespeicherten Kennwerte des elektromagnetischen Aktors (2) wie beispielsweise die Startzeiten (S) des Ankers (21), die Flugzeiten (T) des Ankers (21) und/oder die Beruhigungszeiten (B) des Ankers (21) eines einzelnen elektromagnetischen Aktors (2) miteinander zu vergleichen und bei signifikanter Abweichung eines Kennwerts des Ankers (21) mit anderen ermittelten Kennwerten gleichen Typs des gleichen Ankers (21) des elektromagnetischen Aktors (2) ein Warnsignal auszugeben.

9. Busmodul nach Anspruch 6,
**dadurch gekennzeichnet, dass** die Maschinensteuerung (1) oder die Recheneinheit (40) ausgebildet ist, die Kennwerte des elektromagnetischen Aktors (2) wie beispielsweise die Startzeit (S) des Ankers (21), die ermittelte Flugzeit (T) eines Ankers (21) und/oder die Beruhigungszeit (B) des Ankers (21) eines elektromagnetischen Aktors (2) mit einem Kennwert gleichen Typs zu vergleichen und bei signifikanter Abweichung eines ermittelten Kennwert des Ankers (21) des elektromagnetischen Aktors (2) mit einem vorgegebenen Kennwert des Ankers (21) ein Warnsignal auszugeben.
